**Europäisches Patentamt**

**European Patent Office**

**Office européen des brevets**

(19)

(11) Veröffentlichungsnummer: **0 135 121**
**B1**

# EUROPÄISCHE PATENTSCHRIFT

(12)

(45) Veröffentlichungstag der Patentschrift:
**01.04.87**

(51) Int. Cl.⁴: **H 03 K 3/017**, H 03 K 3/023

(21) Anmeldenummer: **84109510.2**

(22) Anmeldetag: **09.08.84**

(54) **Schaltungsanordnung zum Erzeugen von Rechtecksignalen.**

(30) Priorität: **12.08.83 DE 3329269**

(43) Veröffentlichungstag der Anmeldung:
**27.03.85 Patentblatt 85/13**

(45) Bekanntmachung des Hinweises auf die Patenterteilung:
**01.04.87 Patentblatt 87/14**

(84) Benannte Vertragsstaaten:
**AT CH DE FR GB IT LI NL SE**

(56) Entgegenhaltungen:
**FR - A - 2 425 178**
**GB - A - 2 019 685**

(73) Patentinhaber: **Siemens Aktiengesellschaft Berlin und München, Wittelsbacherplatz 2, D-8000 München 2 (DE)**

(72) Erfinder: **Fischer, Helmut, Dipl.-Ing., Oertlinweg 6, D-8000 München 90 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf eine Schaltungsanordnung zum Erzeugen von Rechtecksignalen entsprechend dem Oberbegriff des Patentanspruchs 1.

Es ist bereits allgemein bekannt, Rechtecksignale zu erzeugen, die die gleiche Folgefrequenz wie Eingangssignale aufweisen und die ein vorgegebenes Tastverhältnis aufweisen. Eine derartige Schaltungsanordnung ist beispielsweise aus GB-A-2 019 685 bekannt, bei der zwei über eine Diode gekoppelte Kondensatoren vorgesehen sind. Die entsprechenden Lade- und Entladezeitkonstanten dieser Kondensatoren werden dazu benutzt, das Zeitintervall zwischen zwei aufeinanderfolgenden Eingangsimpulsen in zwei Zeitabschnitte mit einem vorgegebenen Verhältnis ihrer Dauer zu unterteilen. Der erste Kondensator wird über einen vom Eingangssignal direkt gesteuerten Transistorschalter entladen. Der Verlauf des Entladevorganges hängt daher nicht nur von der unvermeidbaren Entladezeitkonstante, sondern auch von der Zeichenbreite des Eingangsimpulses ab. Weiterhin bestimmt die Spannung am ersten Kondensator während der anschliessenden Aufladung in Abhängigkeit von der Schwellspannung der Diode den Zeitpunkt, wann der zweite Kondensator vom Entlade- in den Ladezustand übergeht. Diese Schwellspannung geht daher unmittelbar in die Toleranzen der Schaltung ein. Schliesslich ist die bekannte Schaltung wohl geeignet den Änderungen der Folgefrequenz der Eingangssignale zu folgen, jedoch findet ein Ausregeln bei kurzzeitigen Schwankungen der Folgefrequenz nicht statt.

Ausserdem ist es bereits allgemein bekannt, derartige Rechtecksignale mit Schaltungsanordnungen zu erzeugen, die eine monostabile Kippstufe als Eingangsstufe besitzen. Diese Kippstufe wird durch die Eingangssignale jeweils gesetzt und nimmt nach einer konstanten Zeitdauer wieder ihre zurückgezogene Lage ein. Bei einer Veränderung der Folgefrequenz der Eingangssignale ändert sich in entsprechender Weise allerdings auch die Folgefrequenz der Ausgangssignale. Da die Zeitdauer, während der die monostabile Kippstufe gesetzt ist, jedoch normalerweise konstant ist, ändert sich bei einer Veränderung der Folgefrequenz der Eingangssignale jedoch das Tastverhältnis.

Eine Weiterbildung dieses allgemeinen Schaltungskonzeptes ist aus FR-A-2 425 178 bekannt, die sich auf einen Signalgenerator für eine elektronische Zündanlage, insbesondere zum Einstellen des Zündzeitpunktes für einen Verbrennungsmotor bezieht. Auch hier besteht, wenn auch bei einem ganz anderen Anwendungsfall, das Problem, bei einer variablen Frequenz von Eingangssignalen ein Ausgangssignal mit gleicher Folgefrequenz und vorgegebenem Tastverhältnis zu schaffen. Die vorgesehene Kippstufe wird von den Eingangssignalen gesetzt und mit deren Ausgangssignal wird ein Kondensator mit einer vorgegebenen ersten Zeitkonstante entladen bis die Entladung einen vorgegebenen Schwellwert erreicht. Zu diesem Zeitpunkt wird ein Komparator leitend gesteuert, der ein Rücksetzsignal für die Kippstufe abgibt. Der Kondensator wird danach mit einer vorgegebenen zweiten Zeitkonstante wieder aufgeladen, bis mit dem nächsten Eingangsimpuls die Kippstufe wieder gesetzt wird.

Diese bekannte Schaltungsanordnung scheint zunächst alle Anforderungen zu erfüllen und arbeitet im Falle der Anwendung bei elektronischen Zündanlagen wohl auch ohne Beanstandungen. Jedoch liegen hier Randbedingungen vor, die nicht immer gegeben sind. Es kann nämlich davon ausgegangen werden, dass beim Starten eines Motors immer von einer zunächst gegen Null gehenden Folgefrequenz ausgegangen wird, dann auch der Kondensator auf seine maximale Ladung aufgeladen ist und insgesamt die Folgefrequenz relativ niedrig ist, d.h. im Bereich bis zu einigen KHz liegt. Bei steigender Folgefrequenz der Eingangssignale, d.h. wachsender Motordrehzahl wird dann auch das Ausgangssignal entsprechend höherfrequent bei annähernd gleichem Tastverhältnis.

Häufig ist jedoch, z.B. bei Servotaktgeneratoren für Magnetplattenspeicher, ein derartig günstiger Betriebsfall nicht gegeben. In dem genannten Anwendungsfall muss davon ausgegangen werden, dass die Eingangssignale normalerweise eine wesentlich höhere Folgefrequenz im Bereich von MHz aufweisen und — was sich besonders erschwerend auswirkt — der Betriebzustand sich im Verhältnis zum obigen Anwendungsfall schlagartig ändert. Das bedeutet, sobald Eingangssignale überhaupt auftreten, erscheinen diese unmittelbar mit einer relativ höheren Folgefrequenz, die sich dann allerdings auch nur — wieder in Relation zu obigem Anwendungsfall — nur noch langsam ändert. In einem solchen Anwendungsfall würde die bekannte Schaltung nicht ausreichend Zeit finden, sich bezüglich deren fest vorgegebenem unteren Schwellwert zu zentrieren. Kritisch ist bei der bekannten Schaltung daher der Anfangszustand, der ihre Anwendung auf sehr kontinuierlich ablaufende Regelvorgänge beschränkt.

Weiterhin sind Synchronisierschaltungen allgemein bekannt, die beispielsweise integrierte Schaltkreise verwenden, die als sogenannte «phase locked loops» im Handel erhältlich sind. Diese Synchronisierschaltungen erzeugen Rechtecksignale, die phasen- und frequenzmässig mit den Eingangssignalen übereinstimmen. Sie erfordern jedoch einen verhältnismässig grossen Aufwand, da sie beispielsweise einen Oszillator beinhalten, der die Rechtecksignale erzeugt und dessen Folgefrequenz in Abhängigkeit von der Phasendifferenz zwischen den Rechtecksignalen und den Eingangssignalen verändert wird.

Insbesondere von dem aus FR-A-2 425 178 bekannten Stand der Technik ausgehend liegt der Erfindung daher die Aufgabe zugrunde, eine weiterentwickelte Schaltungsanordnung zum Erzeugen von Rechtecksignalen anzugeben, deren Folgefrequenz mit der Folgefrequenz der Eingangssignale übereinstimmt und deren Tastverhältnis konstant ist. Diese Schaltungsanordnung soll ausserdem bei besonders geringem Aufwand auch bei diskontinuierlichem Betrieb eine hohe Synchronisierungsfähigkeit besitzen, d.h. ein stabiles Startverhalten aufweisen, das weitgehend unabhängig von dem Ausgangszustand beim Einschalten ist.

Erfindungsgemäss wird die Aufgabe bei der Schaltungsanordnung der eingangs genannten Art durch die im kennzeichnenden Teil des Patentanspruchs 1 angegebenen Merkmale gelöst.

Die Schaltungsanordnung gemäss der Erfindung zeichnet sich insbesondere dadurch aus, dass eine geregelte Ansprechschwelle eingeführt ist, die durch das erste Integrierglied verwirklicht wird. Dieser die Funktion des Komparators bestimmende Schwellwert hängt unmittelbar von der Folgefrequenz ab und variiert entsprechend den Änderungen der Folgefrequenz. Damit wird erreicht, dass sich die Schaltungsanordnung auch bei sprunghaften Änderungen der Folgefrequenz schnell neu zentriert und weiter synchronisationsfähig bleibt.

Die Schaltungsanordnung gemäss der Erfindung hat den weiteren Vorteil, dass sie trotzdem sehr kostengünstig aufgebaut werden kann. Sie kann insbesondere in Form einer Dickschicht- oder Dünnfilmschaltung kostengünstig aufgebaut werden. Die Schaltungsanordnung weist in einem verhältnismässig grossen Frequenzbereich ein konstantes Tastverhältnis auf.

Als erstes und zweites Integrierglied werden insbesondere Kondensatoren vorgesehen. Es ist auch denkbar, anstelle der Kondensatoren Zähler vorzusehen, die durch Zähltakte konstanter Folgefrequenz aufwärts oder abwärts gezählt werden bzw. die aufwärts gezählt und zurückgesetzt werden. Auch der Komparator kann als digitaler Komparator ausgebildet sein, so dass die Schaltungsanordnung ausschliesslich aus integrierten Schaltkreisen herstellbar ist.

Ein Ausführungsbeispiel der Schaltungsanordnung gemäss der Erfindung wird im folgenden anhand der Zeichnungen näher erläutert. Es zeigen:

Fig. 1 ein Blockschaltbild der Schaltungsanordnung,

Fig. 2 Zeitdiagramme von Signalen an verschiedenen Punkten der Schaltungsanordnung,

Fig. 3 ein Schaltbild eines Ausführungsbeispiels der Schaltungsanordnung.

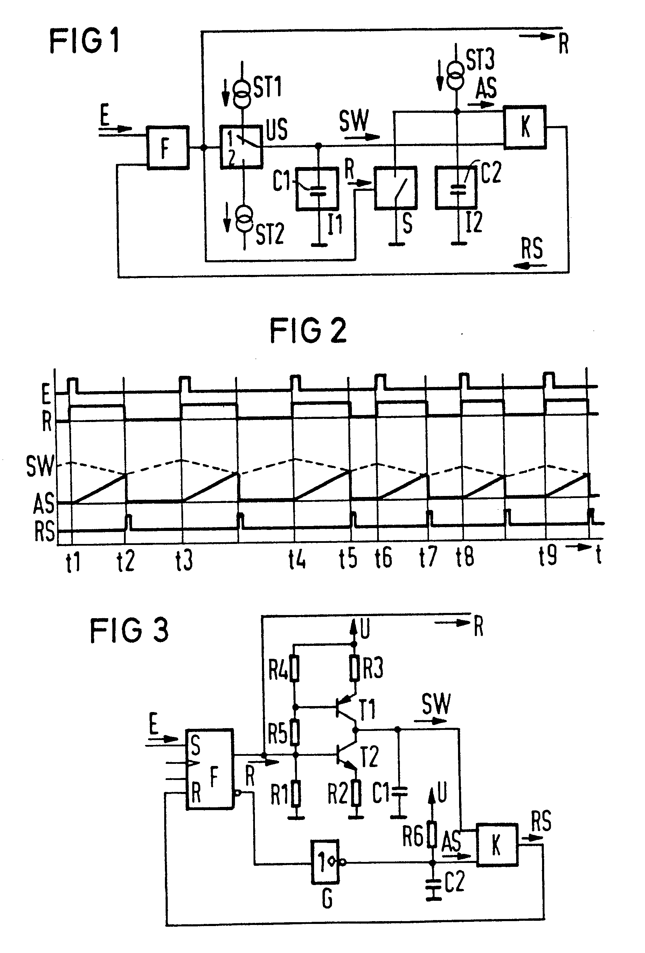

Die in Fig. 1 dargestellte Schaltungsanordnung enthält ein Flipflop F, einen Umschalter US, zwei Integrierglieder I1 und I2, einen Schalter S, drei Stromquellen ST1 bis ST3 und einen Komparator K. Die Integrierglieder I1 und I2 sind als Kondensatoren C1 bzw. C2 ausgebildet. Am Flipflop F liegen an einem Setzeingang Eingangssignale E an und das Flipflop F gibt an seinem Ausgang die Rechtecksignale R ab.

Einzelheiten der Funkton der Schaltungsanordnung werden im folgenden zusammen mit den in Fig. 2 dargestellten Zeitdiagrammen beschrieben.

Bei den in Fig. 2 dargestellten Zeitdiagrammen sind in Abszissenrichtung die Zeit t und in Ordinatenrichtung Momentanwerte von Signalen an verschiedenen Punkten der Schaltungsanordnung dargestellt.

Wenn zum Zeitpunkt t1 das Eingangssignal E den Binärwert 1 annimmt, wird das Flipflop F gesetzt. Das Rechtecksignal R an seinem Ausgang nimmt den Binärwert 1 an und bringt den Umschalter US in die Stellung 2. Der Kondensator C1, der als Spannungswandler den Momentanwert SW aufweist, wird über die Stromquelle ST2 mit verhältnismässig grosser Zeitkonstante entladen. Gleichzeitig wird durch das Rechtecksignal R der Schalter S geöffnet, so dass der Kondensator C2 über die Stromquelle ST3 aufgeladen wird. Diese Aufladung erfolgt mit einer kleineren Zeitkonstante als die Entladung des Kondensators C1.

Zum Zeitpunkt t2 stellt der Komparator K fest, dass der Momentanwert SW am Kondensator C1 mit dem Momentanwert AS übereinstimmt und er setzt mit einem Rücksetzsignal RS das Flipflop F zurück. Hierdurch nimmt das Rechtecksignal R den Binärwert 0 an, wodurch der Umschalter US in die Stellung 1 gebracht wird und der Schalter S geschlossen wird. Durch das Schliessen des Schalters S wird der Kondensator C2 sofort entladen und im entladenen Zustand gehalten. Der Kondensator C1 wird hingegen unter Verwendung der Stromquelle ST1 mit einer verhältnismässig grossen Zeitkonstante aufgeladen.

Zum Zeitpunkt t3 tritt wieder ein Eingangssignal E auf, so dass das Flipflop F wieder gesetzt wird und das Rechtecksignal R wieder den Binärwert 1 annimmt. Nun wiederholen sich zwischen den Zeitpunkten t3 und t4 dieselben Vorgänge wie zwischen den Zeitpunkten t1 und t2.

Wenn die Entladung und die Aufladung in symmetrischer Weise erfolgt, weisen die Rechtecksignale R ein Tastverhältnis von 1:2 auf, d.h. das Impuls/Pausenverhältnis beträgt 1:1. Durch Veränderung der Stromquellen ST1 und ST2 lässt sich jedes beliebige Tastverhältnis bzw. Impuls/Pausenverhältnis einstellen. Dieses Tastverhältnis bzw. Impuls/Pausenverhältnis ist unabhängig von der Folgefrequenz der Eingangssignale E immer konstant.

Wenn sich nach dem Zeitpunkt t4 die Folgefrequenz der Eingangssignale E erhöht, ist die Zeitdauer zwischen t5 und t4, während der der Kondensator C1 entladen wird, grösser als die Zeitdauer zwischen den Zeitpunkten t6 und t5, während der der Kondensator C1 wieder aufgeladen wird, so dass die Spannung am Kondensator C1 kleiner wird. Der Komparator K stellt somit zum Zeitpunkt t7 früher die Übereinstimmung zwischen den Momentanwerten SW und AS fest, so dass das Flipflop F zurückgesetzt wird und sich nach einem kurzen Einschwingvorgang wieder dasselbe Tastverhältnis einstellt. Zwischen den Zeitpunkten t8 und t9 wiederholen sich ähnliche Vorgänge wie zwischen den Zeitpunkten t6 und t8.

Bei dem in Fig. 3 dargestellten Ausführungsbeispiel der Schaltungsanordnung wird das Rechtecksignal R am nichtinvertierenden Ausgang des Flipflops F abgegeben. Dieses Flipflop F weist, ebenso wie ein Gatter G einen Ausgang auf, bei dem der Ausgangstransistor keinen Kollektorwiderstand aufweist.

Wenn das Rechtecksignal R den Binärwert 1 aufweist, so bildet ein Transistor T2 zusammen mit den Widerständen R1 und R2 eine der Stromquelle ST2 entsprechende Konstantstromquelle, die den als Integrierglied I1 dienenden Kondensator C1 entlädt. Wenn das Rechtecksignal R den Binärwert 0 aufweist, bildet ein Transistor T1 zusammen mit Widerständen R3 bis R5 eine der Stromquelle ST1 entsprechende Konstantstromquelle, die den Kondensator C1 auflädt. Die Widerstände R1 bis R5 sind dabei so bemessen, dass der resultierende Entladestrom des Kondensators C1 gerade so gross ist wie der Aufladestrom in dem Fall, dass der Transistor T2 gesperrt ist. Durch die Wahl der Lade- und Entladeträme und der Kapazität des Kondensators C1 kann das dynamische Nachregelverhalten der Schaltungsanordnung bei Veränderung der Frequenz der Eingangssignale E bestimmt werden.

Ein weiterer Widerstand R6 erfüllt die Funktion der Stromquelle ST3 und der Kondensator C2 wirkt als Integrierglied I2. Als Schalter S dient ein am invertierenden Ausgang des Flipflops F angeschlossener als integrierter Baustein ausgebildeter Inverter C, der, wie bereits erwähnt, ebenfalls keinen Kollektorwiderstand aufweist und der den Kondensator C2 jeweils entlädt und im entladenen Zustand hält, solange das Rechtecksignal R den Binärwert 0 aufweist.

Das beschriebene Ausführungsbeispiel illustriert eine Möglichkeit, Rechtecksignale mit einer Schaltungsanordnung zu erzeugen, die grösstenteils aus digitalen Bauelementen, aber auch aus analogen Bausteinen aufgebaut ist. Falls es die Folgefrequenz der Eingangssignale E zulässt, kann die Schaltungsanordnung jedoch auch ausschliesslich aus digitalen Bauelementen aufgebaut werden. In diesem Fall werden die Integrierglieder I1 bzw. I2 aus je einem Zähler gebildet, der durch einen entsprechend hochfrequenten Takt fortgeschaltet wird. Der Schwellenwert SW entspricht einem vorgegebenen Zählerstand. Der Komparator K entspricht dann einem digitalen Vergleicher, der ständig den vom Zähler abgegebenen Zählerstand mit dem vorgegebenen Zählerstand vergleicht. Der Schalter S dagegen entspricht einem Eingang des Zählers, mit dem dieser jeweils auf seinen Ausgangswert zurückgesetzt wird.

Eine derart ausgebildete Schaltungsanordnung hat den Vorteil, dass sie vollständig als integrierte Schaltung herstellbar ist und durch einfache Änderung der Zähltaktfrequenz an unterschiedliche Bedingungen angepasst werden kann.

## Patentansprüche

1. Schaltungsanordnung zum Erzeugen von Rechtecksignalen mit einem vorgegebenen Tastverhältnis und mit einer Folgefrequenz, die mit der Folgefrequenz von Eingangssignalen übereinstimmt, wobei ein mit jedem Eingangssignal gesetztes und durch jeweils ein Rücksetzsignal zurückgesetztes Flipflop, das die Rechtecksignale abgibt, ein Integrierglied, das entladen und wieder aufgeladen wird, wenn das Flipflop gesetzt bzw. zurückgesetzt ist, und ein Komparator vorgesehen ist, der bei Gleichheit des Momentanwertes der Spannung am Integrierglied mit einem Schwellenwert jeweils das Rücksetzsignal erzeugt, gekennzeichnet durch ein weiteres Integrierglied (I2), das aufgeladen bzw. entladen wird, wenn das Flipflop (F) gesetzt ist bzw. zurückgesetzt wird und dessen Momentanwert der Spannung dem Komparator (K) als variabler Schwellenwert zugeführt ist.

2. Schaltungsanordnung nach Anspruch 1, dadurch gekennzeichnet, dass das erste Integrierglied (I1) als Kondensator (C1) ausgebildet ist, der in Abhängigkeit von den Binärwerten der Rechtecksignale (R) mittels eines Umschalters (US) mit einer den Kondensator aufladenden bzw. entladenden ersten bzw.

zweiten Stromquelle (ST1 bzw. ST2) verbunden wird.

3. Schaltungsanordnung nach Anspruch 1 oder Anspruch 2, dadurch gekennzeichnet, dass das zweite Integrierglied (I2) als Kondensator (C2) ausgebildet ist, dem ein Schalter (S) parallel geschaltet ist, der geöffnet bzw. geschlossen ist, wenn das Flipflop (F) gesetzt bzw. zurückgesetzt ist.

4. Schaltungsanordnung nach Anspruch 3, dadurch gekennzeichnet, dass der Schalter (S) als integriertes Verknüpfungsglied (G) vom Offenen-Kollektor-Typ ausgebildet ist, dessen Kollektorwiderstand durch einen diskreten Widerstand (R6) einer den Kondensator (C2) aufladenden Stromquelle (ST3) gebildet wird.

## Claims

1. A circuit arrangement for generating rectangular signals with a predetermined keying ratio and a repetition frequency which corresponds to the repetition frequency of input signals, wherein are arranged a flip-flop set by each input signal and reset by a resetting signal, which emits rectangular signals, an integrating element discharged and recharged when the flip-flop is set or reset, and a comparator which respectively generates a resetting signal if the momentary value of the voltage at the integrating element corresponds to the threshold value, characterised by a further integrating element (I2) which is charged and discharged when the flip-flop (F) is set and reset and whose momentary potential value is supplied to the comparator (K) as a variable threshold value.

2. A circuit arrangement as claimed in Claim 1, characterised in that the first integrating element (I1) is a capacitor (C1), which is connected to a first or second current source (ST1 or ST2 as the case may be) in dependence upon the binary values of the rectangular signals (R) and charges or discharges the capacitor by means of a change-over switch (US).

3. A circuit arrangement as claimed in Claim 1 or Claim 2, characterised in that the second integrating element (I2) is designed as a capacitor (C2), to which a switch (S) is connected in parallel, which switch is opened or closed, as the case may be, when the flip-flop (F) is set or reset.

4. A circuit arrangement as claimed in Claim 3, characterised in that the switch (S) is an integrated logic element (G) of the open collector type, whose collector resistance is formed by a discrete resistance (R6) of a current source (ST3) charging the capacitor (C2).

## Revendications

1. Montage pour produire des signaux rectangulaires possédant un taux d'impulsions prédéterminé et une fréquence de répétition qui coïncide avec la fréquence de répétition de signaux d'entrée, et dans lequel il est prévu une bascule bistable positionnée par chaque signal d'entrée et ramenée à l'état initial respectivement par un signal de remise à l'état initial et qui délivre des signaux rectangulaires, un circuit d'intégration, qui est déchargé et à nouveau chargé lorsque la bascule bistable est positionnée et est ramenée à l'état initial, et un comparateur qui produit effectivement le signal de remise à l'état initial en cas d'égalité entre valeur instantanée de la tension dans le circuit d'intégration et une valeur de seuil, caractérisé par un autre circuit d'intégration (I2), qui est chargé ou déchargé lorsque la bascule bistable (F) est positionnée ou est ramenée à l'état initial et dont la valeur instantanée de la tension est envoyée au comparateur (K) en tant que valeur de seuil variable.

2. Montage suivant la revendication 1, caractérisé par le fait que le premier circuit dintégration (I1) est réalisé sous la forme d'un condensateur (C1), qui est relié, en fonction des valeurs binaires des signaux rectangulaires (R), au moyen d'un commutateur (US), à une première ou une seconde source de courant (ST1 ou ST2) chargeant ou déchargeant le condensateur.

3. Montage suivant la revendication 1 ou 2, caractérisé par le fait que le second circuit d'intégration (I2) est réalisé sous la forme d'un condensateur (C2), en parallèle avec lequel est branché un interrupteur (S) qui est ouvert au fermé lorsque la bascule bistable (F) est positionnée ou est ramenée à l'état initial.

4. Montage suivant la revendication 3, caractérisé par le fait que l'interrupteur (S) est réalisé sous la forme d'un circuit logique intégré (G) du type à collecteur ouvert et dont la résistance de collecteur est formée par une résistance discrète (R6) d'une source de courant (ST3) chargeant le condensateur (C2).

# FIG 1

# FIG 2

# FIG 3